Europäisches Patentamt

European Patent Office

Office européen des brevets

(19)

(11)    EP 0 769 854 B1

(12)    **FASCICULE DE BREVET EUROPEEN**

(45) Date de publication et mention
de la délivrance du brevet:
**20.02.2002   Bulletin 2002/08**

(51) Int Cl.⁷: **H03M 13/00**, G11B 20/18

(21) Numéro de dépôt: **96402208.1**

(22) Date de dépôt: **16.10.1996**

(54) **Système permettant un décodage correct, sous forme d'un message binaire, d'un code magnétique enregistré sur une piste magnétique**

System zur richtigen Binärformatdekodierung eines auf einer magnetischen Spur gespeicherten magnetischen Codes

System enabling correct decoding, in binary message form, of a magnetic code recorded on a magnetic track

(84) Etats contractants désignés:
**DE ES FR GB IT**

(30) Priorité: **20.10.1995  FR 9512368**

(43) Date de publication de la demande:
**23.04.1997   Bulletin 1997/17**

(73) Titulaire: **COMPAGNIE GENERALE D'AUTOMATISME CGA-HBS F-91220 Brétigny sur Orge (FR)**

(72) Inventeurs:
• **Michel, Jacques 94240 l'Hay les Roses (FR)**
• **Trouche, Dominique 91230 Montgeron (FR)**

(74) Mandataire: **Lucas, Laurent Jacques et al Thales Intellectual Property, 13, avenue du Président Salvador Allende 94117 Arcueil Cedex (FR)**

(56) Documents cités:
**EP-A- 0 407 101          US-A- 5 251 077**

• **PATENT ABSTRACTS OF JAPAN vol. 12, no. 380 (P-769), 12 Octobre 1988 & JP-A-63 126080 (FUJITSU), 30 Mai 1988,**
• **PATENT ABSTRACTS OF JAPAN vol. 13, no. 243 (P-768), 7 Juin 1989 & JP-A-01 044627 (FUJITSU), 17 Février 1989,**
• **PATENT ABSTRACTS OF JAPAN vol. 12, no. 154 (P-700), 12 Mai 1988 & JP-A-62 271261 (SANYO), 25 Novembre 1987,**

Il est rappelé que: Dans un délai de neuf mois à compter de la date de publication de la mention de la délivrance du brevet européen, toute personne peut faire opposition au brevet européen délivré, auprès de l'Office européen des brevets. L'opposition doit être formée par écrit et motivée. Elle n'est réputée formée qu'après paiement de la taxe d'opposition. (Art. 99(1) Convention sur le brevet européen).

## Description

La présente invention concerne un système permettant un décodage correct, sous forme d'un message binaire, d'un code magnétique enregistré sur une piste magnétique déposée sur un support, ledit code magnétique pouvant comporter, sur une longueur correspondant à un nombre de b bits appelés "paquet erroné" une altération localisable, ledit codage magnétique étant d'un type faisant apparaître sur la piste magnétique des aimants élémentaires de longueur $\ell_1 = \ell \pm \frac{\ell}{2}$ et $\ell_2 = 2\ell \pm \frac{\ell}{2}$.

Les enregistrements magnétiques sur des supports tels que des tickets, des cartes, etc... sont soumis, en raison de l'utilisation par le public à des détériorations et altérations des messages magnétiquement enregistrés. C'est tout particulièrement le cas pour les supports souples qui parfois subissent des pliures entraînant le plus souvent l'altération du matériau magnétique et donc l'altération de l'information enregistrée.

Une technique connue pour s'affranchir d'un tel inconvénient consiste à répéter une seconde fois le message enregistré. Il est nécessaire toutefois de pourvoir les deux messages d'un complément d'informations permettant de détecter en cas d'erreur sur l'un des messages, et sur l'un seulement, lequel est faux afin de retenir l'autre.

Cette technique présente l'inconvénient de doubler, pour une densité linéaire de bits donnée, la longueur nécessaire pour enregistrer un message, ou de limiter d'une manière importante la longueur possible d'un message sur un support de piste magnétique de longueur donnée.

La présente invention a pour but de s'affranchir d'un tel inconvénient et propose un système qui permet de reconstituer un bloc d'informations manquant ou erroné à condition qu'un tel bloc appelé "paquet erroné" de bits soit unique et localisable. Dans le cas contraire, l'invention permet de détecter que le message est faux, mais pas de le corriger.

Le principe de l'invention est d'utiliser un code de redondance cyclique dit CRC qui est un code de redondance connu possédant des propriétés particulières, associé à une technique particulière, applicable aux enregistrements magnétiques, de localisation d'erreur.

D'une manière générale, le principe des codes de redondance consiste à compléter un bloc d'informations binaires par un ensemble de bits de contrôle défini par une loi, ou application, sur les bits de l'information utile.

Ainsi, pour un message utile de m bits, on ajoute k bits de contrôle, le message final formant donc un mot de n bits = m + k.

La loi de génération des structures de contrôle est telle que pour un message donné, par exemple de m bits, il n'existe qu'une seule structure de contrôle de k bits. En revanche, plusieurs messages distincts de m bits ont la même structure de contrôle de k bits si k < m. Ainsi, pour un message de m bits il y a $2^m$ configurations possibles. Pour chacune de ces $2^m$ configurations, on ajoute k bits de contrôle. On obtient donc $2^m$ configurations de m + k = n bits. L'ensemble de ces $2^m$ configurations de n bits s'appelle "le code de redondance" et une configuration particulière de ce code s'appelle un mot du code. On comprend que le code de redondance contenant $2^m$ mots du code de n bits est un sous ensemble des $2^n$ configurations possibles de n = m + k bits.

La détection d'erreur consiste à vérifier si le message présent de n bits est bien un mot du code de redondance en appliquant aux m bits de message utile la loi de génération des k bits de contrôle et à comparer ces k bits trouvés par application de la loi à ceux effectivement présents dans le mot lu de n bits.

Parmi les codes de redondance, il existe les codes de redondance cycliques.

Un code de redondance cyclique est un code de redondance particulier répondant bien entendu à la définition générale donnée ci-dessus des codes de redondance, mais possédant la propriété caractéristique remarquable que toute permutation circulaire d'un mot du code constitue également un mot du code.

Cette propriété remarquable permet de corriger, si on peut la localiser, une erreur en paquet, c'est-à-dire une erreur constituée par une suite continue de bits. En effet, cette propriété remarquable fait qu'il n'existe aucun couple de mots du code ayant, à l'extérieur d'un paquet quelconque de k bits successifs (k étant le nombre de bits de la structure de contrôle), la même structure. Ceci permet donc de corriger une erreur d'un paquet de bits d'une longueur ≤ k, avec certitude, si toutefois on peut la localiser.

Un code de redondance cyclique dont les mots ont une longueur de n bits comprenant m bits utiles et k bits de contrôle (n = m + k) est ainsi constitué d'une famille de C configurations cycliques distinctes, de n bits, telles que les $2^m$ configurations de n bits chacune qui correspondent aux m bits utiles, sont toutes obtenues et seulement elles, par l'ensemble des permutations circulaires de toutes les configurations cycliques du code.

Un code de redondance cyclique dont les mots ont une longueur de n bits et qui comportent k bits de contrôle est noté C(n, n - k) = C(n, m)

Pour générer un code de redondance cyclique C(n, m), on procède de la façon suivante : un mot binaire de n bits est représenté par un polynôme N(x) de degré n - 1 de n termes :

$$N(x) = a_{n-1}\, x^{n-1} + a_{n-2}\, x^{n-2} + \ldots a_i x^{ni} \ldots + a_1\, x^1 + a_0 x^0$$

Ainsi, le degré $n_i$ des termes consécutifs décroît d'une unité en allant de la gauche vers la droite en partant du degré n - 1 pour aboutir au degré 0. Le degré $n_i$ d'un terme est donc représentatif de l'emplacement du bit qu'il représente dans la structure de n bits.

Le coefficient $a_i$ d'un terme est égal à 0 ou à 1 selon la valeur 0 ou 1 du bit représenté par ce terme.

Ainsi, le mot binaire suivant :

11100110101

est représenté par le polynôme suivant :

$$1.x^{10} + 1.x^9 + 1..x^8 + 0.x^7 + 0.x^6 + 1.x^5 + 1.x^4 + 0.x^3 + 1.x^2 + 0.x + 1.$$

Bien entendu, on élimine les termes nuls et on écrit :

$$x^{10} + x^9 + x^8 + x^5 + x^4 + x^2 + 1$$

Mais lors de la traduction en bits d'un polynôme, il faut bien sûr placer les 0 correspondant aux termes absents.

Ceci étant dit, la théorie des codes de redondance cyclique démontre que :

Un mot de n bit appartient à un code de redondance cyclique ayant k bits de structure de contrôle si le polynôme représentant ces n bits est divisible, dans l'algèbre modulo 2, sans retenue, par un polynôme générateur G(x) de degré k. Ce polynôme générateur G(x) de degré k doit par ailleurs être un diviseur du polynôme $x^n$-1.

On rappelle que l'algèbre modulo 2 sans retenue possède les seuls chiffres suivants : 0 et 1.

a) addition :

$$0 + 0 = 0$$

$$0 + 1 = 1$$

$$1 + 1 = 0$$

$$1 - 1 = 0$$

le + et le - sont identiques. Cette opération est commutative et associative.

b) multiplication :

$$0 \times 1 = 0 \qquad 1 \times 1 = 1$$

$$0 \times 0 = 0$$

cette opération est commutative et associative. Une propriété de cette algèbre est que :

$$f^2(x) = f(x^2) \text{ ex. : } (1+x+x^2)^2 = 1+x^2 + x^4$$

Pour trouver un polynôme G(x) générateur d'un code de redondance cyclique C(n, n-k), il faut donc décomposer en facteurs premiers $x^n$ - 1 et si dans ces facteurs premiers ou par une multiplication de plusieurs de ces facteurs premiers, il existe un polynôme de degré k, ce polynôme sera un polynôme G(x) générateur d'un code C(n, n-k).

Cela peut n'être pas possible. Dans ce cas, on majore fictivement le nombre n de bits de façon à pouvoir trouver un polynôme générateur G(x) d'un code C($n_1$, $n_1$-k) avec $n_1$ = n + n'.

Ceci fait, on fait précéder dans la logique les n bits de n' bits nuls.

Dans ce cas, un mot du code de redondance cyclique comprend n' + n bits et il faut en tenir compte dans les permutations circulaires.

Pour déterminer les k bits de la structure de contrôle à ajouter à un message de m bits, ayant trouvé un polynôme G(x) générateur d'un code C(n, n-K), on agit donc ainsi :

On ajoute aux m bits du message, k bits nuls. On obtient donc un mot de n bits. On représente ce mot de n bits par son polynôme représentatif, de degré n - 1 comme dit précédemment et on divise ce polynôme par G(x) . On obtiendra un reste qui est un polynôme de degré k - 1 ayant donc k termes. Ces k termes sont représentatifs d'une combinaison binaire de k termes que l'on substituera aux k bits nuls.

Quand on dit que le reste est un polynôme de degré k - 1, on veut dire qu'il représente k bits mais il se peut que, de fait, le polynôme représentatif soit de degré inférieur par exemple de degré k - 2, cela veut dire que le terme de degré k - 1 est absent et il représente donc un 0.

Exemple : soit un message binaire de quatre bits 0001 : m = 4.

On souhaite pouvoir détecter une erreur et pouvoir la corriger, si elle est localisable, unique et en paquet et ceci jusqu'à trois bits consécutifs.

On ajoutera donc à ces quatre bits, trois bits de contrôle : k = 3 de façon que le mot formé de sept bits : n = 7 = m + k, soit un mot d'un code de redondance cyclique C(n, n - k) = C(7, 4), il faut donc trouver un G (x) diviseur de $x^n - 1 = x^7 - 1$ qui soit un polynôme de degré k = 3.

Or,

$$x^7 - 1 = (x^3 + x + 1) (x^4 + x^2 + 1)$$

le polynôme $x^3 + x + 1$ est donc un G(x) générateur d'un code C(7, 4).

Pour trouver les k bits à ajouter à 0001 on ajoute trois bits nuls à 0001 soit : 0001000, représenté par $x^3$.

La division de $x^3$ par G(x) donne un reste égal à x + 1 qui représente le message : 011. On substitue donc 011 aux k bits (trois bits) nuls ajoutés au message : soit

0001011, ceci est un mot du code de redondance cyclique C(7, 4) et dans ce mot, les k bits 011 constituent la structure de contrôle du message utile 0001.

L'invention a ainsi pour objet un système permettant un décodage correct, sous forme d'un message binaire, d'un code magnétique enregistré sur une piste magnétique déposée sur un support, ledit code magnétique pouvant comporter, sur une longueur correspondant à un nombre de b bits appelés "paquet erroné", une altération localisable, ledit codage magnétique étant du type faisant apparaître sur la piste magnétique des aimants élémentaires de longueur $\ell_1 = \ell \pm \frac{\ell}{2}$ et $\ell_2 = 2\ell \pm \frac{\ell}{2}$, caractérisé en ce qu'une structure de contrôle sous forme d'un paquet unitaire de k bits est intégrée dans le message en un emplacement répertorié, lesdits k bits étant magnétiquement enregistrés sur la piste et étant déterminés de façon que l'ensemble, constituant un mot de n bits, appartienne à un code de redondance cyclique C(n, n - k) généré par une loi, en ce que la localisation du début d'une éventuelle altération, au cours de la lecture est faite d'après la constatation de l'un ou l'autre des événements suivants :

a) détection d'une longueur d'aimants $> \frac{5\ell}{2}$
b) détection d'une longueur d'aimants $< \frac{\ell}{2}$
c) détection d'une suite continue d'aimants de longueur $\ell_1$ en nombre impair,

en ce que, en une telle occurence, le décodage magnétique en unité binaire s'arrête au bit de rang $N_1 - 1$ décodé et correspondant à l'aimant de longueur correct précédant l'événement a), ou b), ou à l'aimant de longueur $\ell_2$ précédant l'événément c), la fin de l'altération étant localisée de la même manière, mais en procédant à la lecture du mot de n bits, en sens inverse, on obtient ainsi le décodage en sens inverse jusqu'au dernier bit correctement décodé de rang N2 + 1 numéroté en partant de la même origine que pour le bit de rang $N_1 - 1$, en ce que les bits non décodés de rang $N_1$ à $N_2$ compris, au nombre de b = $N_2$ - (N1 - 1) sont recherchés en effectuant une permutation circulaire des n bits de façon à placer les b bits non décodés en fin de configuration et en appliquant à cette configuration, dans laquelle on a fictivement mis des 0 aux b bits manquants, ladite loi de génération du code de redondance cyclique ayant permis la détermination desdits k bits de la structure de contrôle, les b bits trouvés par l'application de la loi étant remis à leur place originelle par une nouvelle permutation circulaire.

L'invention a aussi pour objet un système permettant un décodage correct, sous forme d'un message binaire, d'un code magnétique enregistré sur une piste magnétique déposée sur un support, ledit code magnétique pouvant comporter, sur une longueur correspondant à un nombre de b bits appelés "paquet erroné", une altération localisable, ledit codage magnétique étant du type faisant apparaître sur la piste magnétique des aimants élémentaires de longueur $\ell_1 = \ell + \frac{\ell}{2}$ et $\ell_2 = 2\ell \pm \frac{\ell}{2}$, caractérisé en ce qu'une structure de contrôle sous forme d'un paquet unitaire de k bits est intégrée dans le message en un emplacement répertorié, lesdits k bits étant magnétiquement enregistrés sur la piste et étant déterminés de façon que l'ensemble, constituant un mot de n bits, appartienne à un code de redondance cyclique C(n, n - K) généré par une loi, en ce que la localisation du début d'une éventuelle altération, au cours de la lecture est faite d'après la constatation de l'un ou l'autre des événements suivants :

a) détection d'une longueur d'aimants $> \frac{5\ell}{}$

b) détection d'une longueur d'aimants $< \frac{\ell}{2}$

c) détection d'une suite continue d'aimants de longueur $\ell_1$ en nombre impair,

en ce que, en une telle occurence, le décodage magnétique en unité binaire s'arrête au bit de rang $N_1 - 1$ décodé et correspondant à l'aimant de longueur correct précédant l'événement a), ou b), ou à l'aimant de longueur $\ell_2$ précédant l'événement c), le décodage est ensuite repris à partir du rang $N_1 + k$ numéroté $N_2 + 1$, on obtient ainsi le décodage des n bits à l'exception de k bits de rang $N_1$ à $N_2$ compris, en ce que ces k bits sont recherchés en effectuant une permutation circulaire des n bits de façon à placer les k bits non décodés en fin de configuration et en appliquant à cette configuration, dans laquelle on a fictivement mis des 0 aux k bits manquants, ladite loi de génération du code de redondance cyclique ayant permis la détermination desdits k bits de la structure de contrôle, les k bits trouvés par l'application de la loi étant remis à leur place originelle par une nouvelle permutation circulaire.

Ainsi, dans ce cas, la localisation du paquet erroné n'est effectuée qu'en recherchant son début et on suppose que le paquet est erroné sur k bits.

Selon une autre caractéristique, le mot de n bits comprend m = n - k bits se décomposant en : m1 bits de début de message, m2 bits de message utile, m3 bits de fin de message et m4 bits d'adaptation, m4 étant nul s'il existe un code de redondance cyclique de longueur n = m + k = m1 + m2 + m3 + k, à k bits de contrôle, noté C(n, n - k) et non nul dans le cas contraire, et alors choisis de façon à majorer au plus près la somme m1 + m2 + m3 + k de façon à ce qu'il existe un code C(n, n - k).

Selon une réalisation préférée, dans le cas où il est nécessaire d'avoir des bits d'adaptation au nombre de m4, ils n'existent que logiquement sans être enregistrés magnétiquement sur la piste magnétique. De préférence, ces m4 bits sont des 0 logiques, mais cela n'est pas nécessaire.

Selon une réalisation préférée, l'ordre d'enregistrement des n bits sur la piste magnétique est le suivant :
m1, m2, k, m3.

Bien entendu, lors de l'opération de recherche des k bits de contrôle à ajouter au message m = m1 + m2 + m3, il est nécessaire, par une permutation circulaire, d'appliquer la loi de génération du code de redondance cyclique G(x) sur le message dans l'ordre suivant : m3, m1, m2, k bits nuls. Et une fois que les k bits sont trouvés, on enregistre le message magnétique sur la piste dans l'ordre : m1, m2, k, m3.

On pourrait également enregistrer magnétiquement le message dans l'ordre suivant : m1, k, m2, m3.

Dans ce cas, pour trouver les k bits il faudrait effectuer la permutation circulaire amenant le message dans l'ordre suivant : m2, m3, m1, k bits nuls et une fois déterminés les k bits à substituer aux k bits nuls, on enregistre magnétiquement le message dans l'ordre m1, k, m2, m3.

De préférence, lorsqu'il y a des bits m4 d'adaptation, ils sont placés avant les bits m1, qu'ils soient magnétiquement enregistrés ou seulement logiquement présents.

Comme il a été expliqué plus haut, la loi de génération du code de redondance cyclique C(n, n - k) est un polynôme générateur G(x) de degré k diviseur du polynôme $x^n - 1$ dans l'algèbre modulo 2 sans retenue.

Ainsi, l'invention consiste donc à utiliser un code de redondance cyclique CRC associé à une technique de localisation d'erreur.

On va maintenant donner un exemple en se référant au dessin annexé dans lequel :

La figure 1 représente un titre magnétique.

La figure 2 représente le codage de la piste magnétique.

La figure 3 représente le signal décodé de la lecture de la piste.

La figure 4 représente le message

Le message à inscrire est le suivant : 10100011011. Ce message comprend m bits, m = 11 ; il se répartit de la façon suivante :

m1 bits de début de message : m1 = 2 $\rightarrow$ 10
m2 bits de message utile : m2 = 7 $\rightarrow$ 1000110
m3 bits de fin de massage : m3 = 2 $\rightarrow$ 11
m = 11 = m1 + m2 + m3

on veut pouvoir corriger jusqu'à trois bits (en paquet), il faut donc ajouter trois bits de contrôle : k= 3.

Ces trois bits, seront enregistrés sur la piste entre m2 et m3., c'est-à-dire comme suit :
101000110... 11

Ce mot doit faire partie d'un code CRC C(n, n - k) = C(14, 11).

Existe-t-il un polynôme générateur G(x) de degré k = 3 permettant un tel code ? Il doit être un diviseur de $x^n$ - 1 = $x^{14}$ - 1. Il existe en effet, c'est : G(x) = $x^3$ + x + 1 qui représente 1011.

Pour trouver les k bits remplaçant les points, on effectue une permutation circulaire du message de quatorze bits de façon à placer les k bits à trouver en fin de mot et en leur donnant une valeur nulle. On obtient :

11101000110000

La division de ceci par G(x) : 1011 donne comme reste : 001 : le mot du code est donc :

11101000110001

Pour l'enregistrement sur la piste magnétique, on effectuera une permutation circulaire de façon à placer les trois bits de contrôle 001 entre m2 et m3.

On écrira donc :

10100011000111

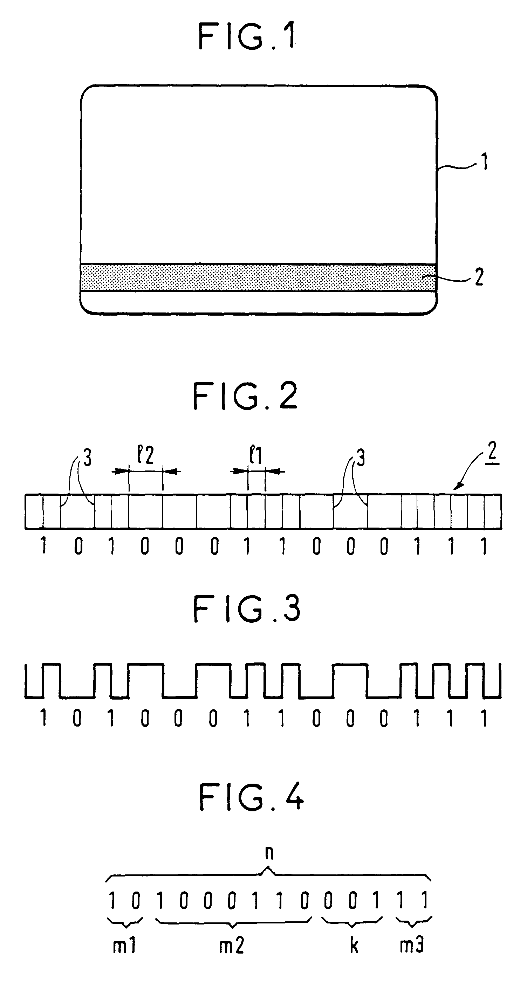

La figure 1 montre une carte 1 portant une piste magnétique 2.

La figure 2 représente le codage magnétique de la piste magnétique 2.

La figure 3 représente le signal résultant de la lecture de la piste magnétique.

La figure 4 montre le message décodé.

Le codage utilisé est le code bi-fréquence F/2F qui fait apparaître sur la piste uniquement des aimants de longueur simple $\ell$ ou double $2\ell$ avec une tolérance de $\pm \frac{\ell}{2}$ pour chacun : on a donc deux longueurs d'aimants : $\ell_1 = \ell \pm \frac{\ell}{2}$ et $\ell_2 = 2\ell \pm \frac{\ell}{2}$.

La figure 3 montre le signal résultant de la lecture de la piste magnétique 2.

La figure 4 montre le message binaire décomposé en ses parties : m1 bits de début de message, m2 bits de message utile, k bits de contrôle et m3 bits de fin de message.

Au moment de la lecture, celle-ci se fait à vitesse constante, la durée entre deux transitions magnétiques, représentées par les traits verticaux 3 sur la figure 2, est donc proportionnelle à la longueur $\ell_1$ ou $\ell_2$.

On obtient donc une table donnant la suite des longueurs $\ell_1$ ou $\ell_2$ traduite ensuite en bits 0 et 1.

La localisation du début d'une erreur en paquet dans le message lu est faite en détectant l'un des événements suivants :

a) la longueur d'un aimant est supérieure à $\frac{5\ell}{2}$
b) la longueur d'un aimant est inférieure à $\frac{\ell}{2}$
c) on détecte un nombre impair successif d'aimants courts $\ell_1$.

Dans ce cas, on arrête le décodage au dernier bit bien décodé et, soit on reprend le décodage k bits plus loin (k = 3 dans l'exemple décrit), soit on effectue le décodage en lisant la piste à partir de la fin de façon à détecter la fin de l'erreur.

Une fois localisée l'erreur, on place logiquement le paquet de bits non décodés en fin de message en donnant une valeur nulle à ces bits, et on applique la loi G(x) pour trouver la valeur de ces bits. Il ne reste plus qu'à placer ces bits au bon endroit par permutation circulaire.

Exemple : le message ci-dessus n'a pu être décodé que comme suit :

10100 ??? 000111

On effectue alors la permutation circulaire suivante :

00011110100 ???

et l'on met des 0 à a place des ?

00011110100000

On divise ceci par G(x) = $x^3$ + x + 1 qui représente 1011 (dans l'algèbre modulo 2 sans retenue) on trouve le reste suivant : 011 $\rightarrow$ x + 1 le mot du code est donc : 00011110100011 et les bits manquants 011 sont remis à leur place : 10100011000111

on retrouve bien le message.

Si le paquet de bits manquants d'une longueur de b bits est > k, dans le cas présent si b > 3, alors il y a $2^{b-3}$ solutions possibles.

Exemple : si b = 5, on a 5 - 3 = 2 donc $2^2$ = 4 solutions possibles.

En pratique on agit comme suit :

On place comme précédemment les b bits manquants en fin de mot :

101?????000111

ce qui donne : 000111101?????

et l'on forme quatre mots avec toutes les solutions possibles pour les deux premiers bits manquants et en mettant des 0 aux trois derniers bits manquants :

1/00011110100000

2/00011110111000
3/00011110110000
4/00011110101000

On applique la loi G(x) à chacune des quatre solutions pour trouver le reste, ce qui donne

pour 1/ 011 $\rightarrow$ 00011110100011
pour 2/ 110 $\rightarrow$ 00011110111110
pour 3/ 101 $\rightarrow$ 00011110110101
pour 4/ 000 $\rightarrow$ 00011110101000

On effectue une permutation circulaire des quatre solutions pour replacer les cinq derniers bits à leur place :

1/ 10100011000111

2/ 10111110000111

3/ 10110101000111

4/ 10101000000111
$\quad$ $m_1$ $\quad$ $b$ $\quad$ $k$ $\quad$ $m_3$

$m_2$

Le bon mot est alors recherché par un critère de vraisemblance. Ici, il s'agit du premier.

Dans l'exemple cité, le message m avait onze bits et l'on voulait trois bits de contrôle k, soit quatorze bits en tout : n = 14, il fallait donc trouver un G(x) pour un code C(n, n-k) = C(14, 11). On a vu qu'un tel G(x) existait, c'est $x^3 + x + 1 \rightarrow 1011$.

Dans le cas où le message m a douze bits par exemple, et que l'on souhaite toujours k = 3 bits de contrôle, il faut donc trouver un G(x) de degré 3 générateur d'un code C(15, 12).

Or, il n'existe pas de G(x) de degré 3 diviseur de $x^n$ - 1 = $x^{15}$ - 1, on va donc chercher une valeur $n_1$, majorant au plus près le nombre n de façon à pouvoir former un code C($n_1$, $n_1$-3) ayant un polynôme générateur G(x).

On trouve que pour $n_1$ = 16 c'est possible et l'on constitue ainsi un code C(16, 13), le polynôme G(x) est $x^3 + x^2 + x + 1$. La longueur d'un mot du code est $n_1$ = 16 bits, $n_1$ - n = 1 bit.

On ajoute alors au message de m bits un nombre de bit d'adaptation m4 = 1. Il n'est pas nécessaire de l'enregistrer magnétiquement, mais il faut en tenir compte dans les permutations circulaires et donc le placer logiquement. On peut le placer où l'on veut et lui donner la valeur que l'on veut : 0 ou 1, il suffit seulement que l'on connaisse sa valeur et sa place.

L'invention ne permet pas, compte tenu de la technique de localisation adoptée, de corriger une erreur dans laquelle il n'y a pas d'anomalie de la structure magnétique par ce qu'alors, on ne peut pas localiser l'erreur. C'est le cas si un 0 devient un 1 ou vice versa. On peut cependant détecter que le message est erroné en appliquant la loi au message lu et en constatant que le reste de la division par G(x) n'est pas nul.

Cependant, les principales causes d'erreurs observables dans les enregistrements magnétiques sont détectées par les critères adoptés de localisation d'erreur. Ces causes sont les suivantes :

-   Il s'agit de pertes de transitions dues à un trou dans le message : piste endommagée par exemple ou à un évanouissement local du signal de détection s'abaissant au-dessous des seuils de détection.
-   Surcroît de transitions dû essentiellement aux bruits qui aléatoirement peuvent dépasser le seuil de détection.
-   Variations de durées entre transitions dues à des causes diverses de bruits de pistes, "scintillement" de la vitesse de défilement des titres dans l'opération de lecture magnétique.
-   Superposition locale de deux messages différents en raison de déficiences du contact tête-piste lors de l'écriture magnétique.

**Revendications**

**1.**   Système permettant un décodage correct, sous forme d'un message binaire, d'un code magnétique enregistré sur une piste magnétique (2) déposée sur un support (1), ledit code magnétique pouvant comporter, sur une longueur correspondant à un nombre de b bits appelés "paquet erroné", une altération localisable, ledit codage magnétique étant d'un type faisant apparaître sur la piste magnétique (2) des aimants élémentaires de longueur $\ell_1 = \ell \pm \frac{\ell}{2}$ et $\ell_2 = 2\ell \pm \frac{\ell}{2}$, **caractérisé en ce qu'**une structure de contrôle sous forme d'un paquet unitaire de k bits est intégrée dans le message en un emplacement répertorié, lesdits k bits étant magnétiquement enregistrés sur la piste et étant déterminés de façon que l'ensemble, constituant un mot de n bits, appartienne à un code de redondance cyclique C(n, n - K) généré par une loi, **en ce que** la localisation du début d'une éventuelle altération, au cours de la lecture est faite d'après la constatation de l'un ou l'autre des événements suivants :

    a) détection d'une longueur d'aimants $> \frac{5\ell}{2}$
    b) détection d'une longueur d'aimants $< \frac{\ell}{2}$
    c) détection d'une suite continue d'aimants de longueur $\ell_1$ en nombre impair,

    **en ce que**, en une telle occurence, le décodage magnétique en unité binaire s'arrête au bit de rang $N_1 - 1$ décodé et correspondant à l'aimant de longueur correct précédant l'événement a), ou b), ou à l'aimant de longueur $\ell_2$ précédant l'événement c), la fin de l'altération étant localisée de la même manière, mais en procédant à la lecture du mot de n bits, en sens inverse, on obtient ainsi le décodage en sens inverse jusqu'au dernier bit correctement décodé de rang $N_2 + 1$ numéroté en partant de la même origine que pour le bit de rang $N_1 - 1$, **en ce que** les bits non décodés de rang $N_1$ à $N_2$ compris, au nombre de b = $N_2 - (N_1 - 1)$ sont recherchés en effectuant une permutation circulaire des n bits de façon à placer les b bits non décodés en fin de configuration et en appliquant à cette configuration, dans laquelle on a fictivement mis des 0 aux b bits manquants, ladite loi de génération du code de redondance cyclique ayant permis la détermination desdits k bits de la structure de contrôle, les b bits trouvés par l'application de la loi étant remis à leur place originelle par une nouvelle permutation circulaire.

**2.** Système permettant un décodage correct, sous forme d'un message binaire, d'un code magnétique enregistré sur une piste magnétique (2) déposée sur un support (1), ledit code magnétique pouvant comporter, sur une longueur correspondant à un nombre de b bits appelés "paquet erroné", une altération localisable, ledit codage magnétique étant d'un type faisant apparaître sur la piste magnétique (2) des aimants élémentaires de longueur $\ell_1 = \ell \pm \frac{\ell}{2}$ et $\ell_2 = 2\ell \pm \frac{\ell}{2}$, **caractérisé en ce qu'**une structure de contrôle sous forme d'un paquet unitaire de k bits est intégrée dans le message en un emplacement répertorié, lesdits k bits étant magnétiquement enregistrés sur la piste et étant déterminés de façon que l'ensemble, constituant un mot de n bits, appartienne à un code de redondance cyclique C(n, n - k) généré par une loi, en ce que la localisation du début d'une éventuelle altération, au cours de la lecture est faite d'après la constatation de l'un ou l'autre des événements suivants :

    a) détection d'une longueur d'aimants $> \frac{5\ell}{2}$
    b) détection d'une longueur d'aimants $< \frac{\ell}{2}$
    c) détection d'une suite continue d'aimants de longueur $\ell_1$ en nombre impair,

    en ce que, en une telle occurence, le décodage magnétique en unité binaire s'arrête au bit de rang $N_1 - 1$ décodé et correspondant à l'aimant de longueur correct précédant l'événerrent a), ou b), ou à l'aimant de longueur $\ell_2$ précédant l'événement c), le décodage est ensuite repris à partir du rang $N_1 + k$ numéroté $N_2 + 1$, on obtient ainsi le décodage des n bits à l'exception de k bits de rang $N_1$ à $N_2$ compris, en ce que ces k bits sont recherchés en effectuant une permutation circulaire des n bits de façon à placer les k bits non décodés en fin de configuration et en appliquant à cette configuration, dans laquelle on a fictivement mis des 0 aux k bits manquants, ladite loi de génération du code de redondance cyclique ayant permis la détermination desdits k bits de la structure de contrôle, les k bits trouvés par l'application de la loi étant remis à leur place originelle par une nouvelle permutation circulaire.

**3.** Système selon l'une des revendications 1 ou 2, **caractérisé en ce que** le mot de n bits comprend m = n - k bits se décomposant en : m1 bits de début de message, m2 bits de message utile, m3 bits de fin de message et m4 bits d'adaptation, m4 étant nul s'il existe un code de redondance cyclique de longueur n = m + k = m1 + m2 + m3 + k, à k bits de contrôle, noté C(n, n - k) et non nul dans le cas contraire, et alors choisis de façon à majorer au plus près la somme m1 + m2 + m3 + k de façon à ce qu'il existe un code C(n, n - k).

**4.** Système selon la revendication 3, **caractérisé en ce que** lesdits m4 bits d'adaptation n'existent que logiquement sans être enregistrés magnétiquement sur la piste magnétique.

**5.** Système selon la revendication 4, **caractérisé en ce que** lesdits m4 bits sont des 0 logiques.

**6.** Système selon l'une des revendications 4 ou 5, **caractérisé en ce que** l'ordre d'enregistrement des bits sur la piste magnétique est le suivant : m1, m2, k, m3.

**7.** Système selon la revendication 6, **caractérisé en ce que** les m4 bits non enregistrés magnétiquement sont placés logiquement avant les bits m1.

**8.** Système selon l'une des revendications précédentes, **caractérisé en ce que** la loi de génération dudit code de redondance cyclique est un polynôme générateur G(x) de degré k diviseur du polynôme $x^n-1$ dans l'algèbre modulo 2 sans retenue.

**9.** Système selon la revendication 8, **caractérisé en ce que** lesdits k bits de contrôle sont obtenus après avoir placé logiquement par permutation circulaire, l'ensemble du message de n - k bits dans l'ordre suivant : m3, m4, m1, m2 et en ajoutant logiquement, après les bits m2, k bits nuls puis en représentant la structure de n bits ainsi formée par un polynôme N(x) de degré n - 1, chaque terme du polynôme ayant un degré correspondant au rang du bit dans la structure, le premier bit ayant un degré n - 1, le deuxième un degré n - 2, etc... jusqu'au dernier ayant un degré nul et chaque terme du polynôme ayant un coefficient $a_i$ égal à 0 ou 1 selon la valeur 0 ou 1 du bit représenté par le terme considéré du polynôme, ledit polynôme ainsi formé est ensuite divisé par ledit polynôme générateur G(x), le reste de la division constituant un polynôme R(x) représentatif d'une structure de k bits qui sont substitués au k bits nuls.

**10.** Système selon l'une des revendications précédentes, **caractérisé en ce que** $b \leq k$.

**11.** Système selon l'une des revendications 1 à 9, **caractérisé en ce que** dans le cas ou b > k, la recherche des b bits erronés conduit à $2^{b-k}$ solutions qui sont successivement trouvées en donnant successivement aux b - k premiers bits du paquet erroné de b bits les diverses configurations possibles, on utilise alors pour le choix de l'une de ces $2^{b-k}$ solutions trouvées un critère de vraisemblance.

**Patentansprüche**

**1.** System zur richtigen Decodierung eines magnetischen Codes, der auf einer auf einem Träger (1) aufgebrachten magnetischen Spur (2) gespeichert ist, in Form einer binären Nachricht, wobei der magnetische Code auf einer Länge, die einer als "fehlerhaftes Paket" bezeichneten Anzahl von b Bits entspricht, eine lokalisierbare Abweichung aufweisen kann, wobei die magnetische Codierung von einem Typ ist, bei dem auf der magnetischen Spur (2) Elementarmagnete der Länge $l_1 = l \pm l/2$ und $l_2 = 2\,l \pm l/2$ auftreten, **dadurch gekennzeichnet, dass** eine Kontrollstruktur in Form eines einheitlichen Pakets von k Bits in die Nachricht an einer verzeichneten Stelle integriert ist, wobei die k Bits magnetisch auf der Spur aufgezeichnet sind und so festgelegt sind, dass die Gesamtheit, die ein Wort von n Bits bildet, zu einem nach einer Regel erzeugtem zyklischen Redundanzcode C(n, n - K) gehört, dass die Lokalisierung des Beginns einer eventuellen Abweichung im Laufe des Lesens nach der Feststellung des einen oder anderen der folgenden Ereignisse stattfindet:

a) Erfassen einer Magnetenlänge > 5 $l$/2

b) Erfassen einer Magnetenlänge < $l$/2

c) Erfassen einer kontinuierlichen Folge von Magneten der Länge $l_1$ von ungerader Anzahl,

und dass bei einem solchen Vorkommnis die magnetische Decodierung als Binäreinheit decodierten Bit des Rangs $N_1-1$ anhält, das dem dem Ereignis a) oder b) vorangehenden Magneten mit korrekter Länge oder dem dem Ereignis c) vorangehenden Magneten mit Länge $l_2$ entspricht, dass das Ende der Abweichung in der gleichen Weise lokalisiert wird, wobei aber das Wort von n Bits in entgegengesetzter Richtung gelesen wird, dass so die Decodierung in Gegenrichtung bis zum letzten korrekt decodierten Bit vom Rang $N_2+1$, nummeriert ausgehend vom gleichen Ursprung wie für das Bit vom Rang $N_1-1$, erhalten wird, dass die $b = N_2-(N_1-1)$ nicht decodierten Bits vom Rang $N_1$ bis $N_2$ einschließlich gesucht werden durch Durchführen einer zirkularen Permutation der n Bits, so dass die nicht decodierten b Bits am Ende der Konfiguration platziert werden, und Anwenden der zyklischen Redundanzcode-Erzeugungsregel, die die Bestimmung der k Bits der Steuerstruktur ermöglicht hat, auf diese Konfiguration, in der fiktiv die b fehlenden Bits gleich 0 gesetzt sind, und dass die durch Anwendung der Regel gefundenen b Bits durch eine neue Zirkularpermutation an ihren ursprünglichen Platz zurückversetzt werden.

**2.** System zur richtigen Decodierung eines magnetischen Codes, der auf einer auf einem Träger (1) aufgebrachten magnetischen Spur (2) gespeichert ist, in Form einer binären Nachricht, wobei der magnetische Code auf einer Länge, die einer als "fehlerhaftes Paket" bezeichneten Anzahl von b Bits entspricht, eine lokalisierbare Abweichung aufweisen kann, wobei die magnetische Codierung von einem Typ ist, bei dem auf der magnetischen Spur (2) elementare Magnete der Länge $l_1 = l \pm l/2$ und $l_2 = 2\, l \pm l/2$ auftreten, **dadurch gekennzeichnet, dass** eine Kontrollstruktur in Form eines einheitlichen Pakets von k Bits in die Nachricht an einer verzeichneten Stelle integriert ist, wobei die k Bits auf der Spur magnetisch aufgezeichnet sind und so festgelegt sind, dass die Gesamtheit, die ein Wort von n Bits bildet, zu einem nach einer Regel erzeugten zyklischen Redundanzcode C(n, n-k) gehört, und dass die Lokalisierung des Anfangs einer eventuellen Abweichung im Laufe des Lesens nach Feststellung des einen oder anderen der folgenden Ereignisse stattfindet:

    a) Erfassung einer Magnetenlänge > 5 $l/2$

    b) Erfassung einer Magnetenlänge < $l/2$

    c) Erfassung einer kontinuierlichen Folge von Magneten der Länge $l_1$ von ungerader Anzahl,

und dass bei einem solchen Vorkommnis die magnetische Decodierung als Binäreinheit beim decodierten Bit vom Rang $N_1$-1 aufhört, das dem Magneten mit korrekter Länge, der dem Ereignis a) oder b) vorangeht, oder dem Magneten der Länge $l_2$, der dem Ereignis c) vorangeht, entspricht, dass die Codierung anschließend ausgehend vom Rang $N_1$+k, mit $N_2$+1 nummeriert, wieder aufgenommen wird, dass so die Decodierung der n Bits mit Ausnahme von k Bits vom Rang $N_1$ bis $N_2$ einschließlich vorgenommen wird, und dass diese k Bits gesucht werden, indem eine zirkulare Permutation der n Bits vorgenommen wird, so dass die k nicht decodierten Bits am Ende der Konfiguration platziert werden, und auf diese Konfiguration, in der die k fehlenden Bits fiktiv auf 0 gesetzt sind, die Regel zur Erzeugung des zyklischen Redundanzcodes angewendet wird, die die Festlegung der k Bits der Kontrollstruktur ermöglicht hat, wobei die durch Anwendung der Regel gefundenen k Bits durch eine neue zirkulare Permutation an ihren ursprünglichen Platz zurückversetzt werden.

**3.** System nach einem der Ansprüche 1 oder 2, **dadurch gekennzeichnet, dass** das Wort von n Bits m = n-k Bits umfasst, die aufgeteilt sind in m1 Nachricht-Anfangsbits, m2 Nutz-Nachrichtenbits, m3 Nachrichten-Endbits und m4 Anpassungsbits wobei m4 Null ist, wenn ein zyklischer Redundanzcode der Länge n = m+k = m1 + m2 + m3 + k mit k Kontrollbits, mit C(n, n-k) bezeichnet, existiert, und andernfalls nicht Null ist und dann so gewählt wird, dass die Summe m1 + m2 + m3 + k geringstmöglich so erhöht wird, dass ein Code C(n, n-k) existiert.

**4.** System nach Anspruch 3, **dadurch gekennzeichnet, dass** die m4 Anpassungsbits nur logisch existieren, ohne magnetisch auf der Magnetspur aufgezeichnet zu sein.

**5.** System nach Anspruch 4, **dadurch gekennzeichnet, dass** die m4 Bits logisch Nullen sind.

**6.** System nach einem der Ansprüche 4 oder 5, **dadurch gekennzeichnet, dass** die Reihenfolge der Aufzeichnung der Bits auf der Magnetspur die folgende ist: m1, m2, k, m3.

**7.** System nach Anspruch 6, **dadurch gekennzeichnet, dass** die m4 nicht magnetisch aufgezeichneten Bits logisch vor den Bits m1 platziert werden.

**8.** System nach einem der vorhergehenden Ansprüche, **dadurch gekennzeichnet, dass** die Regel zur Erzeugung des zyklischen Redundanzcodes ein Generatorpolynom G(x) vom Grad k ist, das in der Modulo-2-Algebra durch das Polynom $x^n$-1 ohne Rest teilbar ist.

**9.** System nach Anspruch 8, **dadurch gekennzeichnet, dass** die k Kontrollbits erhalten werden, nachdem durch zirkulare Permutation die Gesamtheit der Nachricht aus n-k Bits in die folgende Reihenfolge gebracht worden ist: m3, m4, m1, m2, und in dem nach den Bits m2 k Null-Bits logisch hinzugefügt werden, dann die so gebildete Struktur von n Bits durch ein Polynom N(x) vom Grad n-1 dargestellt wird, wobei jeder Term des Polynoms einen Grad hat, der dem Rang des Bits in der Struktur entspricht, das erste Bit einen Grad n-1, das zweite einen Grad n-2 hat, etc., bis zum letzten mit einem Grad 0, und dass jeder Term des Polynoms einen Koeffizienten $a_i$ gleich 0 oder 1 je nach dem Wert 0 oder 1 des von dem betreffenden Term des Polynoms dargestellten Bits hat, dass das so gebildete Polynom anschließend durch das Generatorpolynom G(x) geteilt wird, wobei der Rest der Division ein Polynom R(x) bildet, das für eine Struktur von k Bits repräsentativ ist, die für die k Null-Bits gesetzt werden.

**10.** System nach dem der vorhergehenden Ansprüche, **dadurch gekennzeichnet, dass** b ≤ k.

**11.** System nach einem der Ansprüche 1 bis 9, **dadurch gekennzeichnet, dass** in dem Fall, wo b > k ist, die Suche der b fehlerhaften Bits zu $2^{b-k}$ Lösungen führt, die nacheinander gefunden werden, indem den b-k ersten Bits des fehlerhaften Pakets aus b Bits die diversen möglichen Konfigurationen gegeben werden, und dass dann für die Auswahl einer der $2^{b-k}$ gefundenen Lösungen ein Wahrscheinlichkeitskriterium verwendet wird.

**Claims**

**1.** A system enabling a magnetic code recorded on a magnetic track (2) deposited on a medium (1) to be decoded properly in the form of a binary message, said magnetic code possibly including locatable spoiling over a length corresponding to a number $\underline{b}$ of bits referred to as an "error packet", said magnetic coding being of a type that causes elementary magnets to appear on the magnetic track (2) of length $\ell_1 = \ell \pm \ell/2$ and of length $\ell_2 = 2\ell \pm \ell/2$, the system being **characterized in that** a check structure in the form of a unitary packet of $\underline{k}$ bits is integrated in the message at a known location, said $\underline{k}$ bits being magnetically recorded on the track and being determined in such a manner that taken together, the message and the control structure constituting an n-bit word, belongs to a cyclic redundancy code C(n,n-k) generated by a relationship, **in that** the location of the beginning of any spoiling encountered during reading, is determined by observing one or other of the following events:

a) a magnet of length > $5\ell/2$ is detected;
b) a magnet of length < $\ell/2$ is detected;
c) a continuous run comprising an odd number of magnets of length $\ell_1$ is detected;

**in that**, in such an event, the magnetic decoding into binary units stops at decoded bit of rank $N_1$-1 corresponding to the last magnet of correct length preceding event a) or b) or to the last magnet of length $\ell_2$ preceding event c), the end of the spoiling being located in the same manner, but by reading the n-bit word in the opposite direction, thereby obtaining decoding in the opposite direction as far as the last properly decoded bit of rank $N_2$+1 counting from the same origin as for the bit of rank $N_1$-1, and **in that** the non-decoded bits of ranks $N_1$ to $N_2$ included, of number b = $N_2$-($N_1$-1) are determined by applying circular permutation to the $\underline{n}$ bits so as to place the $\underline{b}$ non-decoded bits at the end of the configuration, and by applying said relationship for generating the cyclic redundancy code that was used to determine said $\underline{k}$ check-structure bits to said configuration with the $\underline{b}$ missing bits being provisionally reset to zero, the $\underline{b}$ bits found by applying the relationship then being returned to their original position by a new circular permutation.

**2.** A system enabling a magnetic code recorded on a magnetic track (2) deposited on a medium (1) to be decoded properly in the form of a binary message, said magnetic code possibly including locatable spoiling over a length corresponding to a number $\underline{b}$ of bits referred to as an "error packet", said magnetic coding being of a type that causes elementary magnets to appear on the magnetic track (2) of length $\ell_1 = \ell \pm \ell/2$ and of length $\ell_2 = 2\ell \pm \ell/2$, the system being **characterized in that** a check structure in the form of a unitary packet of $\underline{k}$ bits is integrated in the message at a known location, said $\underline{k}$ bits being magnetically recorded on the track and being determined in such a manner that taken together, the message and the control structure constituting an n-bit word, belongs to a cyclic redundancy code C(n,n-k) generated by a relationship, **in that** the location of the beginning of any spoiling encountered during reading, is determined by observing one or other of the following events:

a) a magnet of length > $5\ell/2$ is detected;
b) a magnet of length < $\ell/2$ is detected;
c) a continuous run comprising an odd number of magnets of length $\ell_1$ is detected;

**in that**, in such an event, the magnetic decoding into binary units stops at the decoded bit of rank $N_1$-1 corresponding to the last magnet of correct length preceding event a) or b) or to the last magnet of length $\ell_2$ preceding event c), decoding then continuing from rank $N_1$+k, written as $N_2$+1, thereby decoding the $\underline{n}$ bits with the exception of the $\underline{k}$ bits of ranks $N_1$ to $N_2$ included, and **in that** these $\underline{k}$ bits are determined by applying circular permutation to the $\underline{n}$ bits so as to place the $\underline{k}$ non-decoded bits at the end of the configuration, and by applying said relationship for generating the cyclic redundancy code that was used to determine said $\underline{k}$ check-structure bits to said configuration with the $\underline{k}$ missing bits being provisionally reset to zero, the $\underline{k}$ bits found by applying the relationship then being returned to their original position by a new circular permutation.

3. A system according to claim 1 or 2, **characterized in that** the n-bit word comprises m = n - k bits made up of m1 start-of-message bits, m2 message data bits, m3 end-of-message bits, and m4 padding bits, where m4 is zero if there exists a cyclic redundancy code of length n = m + k = m1 + m2 + m3 + k with k̲ check bits, written C(n,n-k) and being non-zero otherwise, in which case m4 is chosen so as to increase the sum m1 + m2 + m3 + k by as little as possible for there to exist a code C(n,n-k).

4. A system according to claim 3, **characterized in that** said m4 padding bits exist only logically and are not recorded magnetically on the magnetic track.

5. A system according to claim 4, **characterized in that** said m4 bits are logic 0s.

6. A system according to claim 4 or 5, **characterized in that** recording takes place on the magnetic track in the following order: m1, m2, k̲, m3.

7. A system according to claim 6, **characterized in that** the m4 bits that are not magnetically recorded are placed logically in front of the m1 bits.

8. A system according to any preceding claim, **characterized in that** the relationship for generating said cyclic redundancy code is a generator polynomial G(x) of the degree k̲ which divides the polynomial $x^n$-1 without remainder in modulo-2 algebra.

9. A system according to claim 8, **characterized in that** the said k̲ check bits are obtained after logically placing the entire message of n-k bits in the following order: m3, m4, m1, m2 by circular permutation, and by logically adding k̲ zero bits after the m2 bits, then representing the resulting n-bit structure by a polynomial N(x) of degree n-1, each term of the polynomial of degree corresponding to the rank of one of the bits in the structure, the first bit being of degree n-1, the second of degree n-2, etc...., to the last bit which is of degree zero, and each term of the polynomial having a coefficient $a_i$ equal to 0 or 1 depending on whether the bit represented by that term of the polynomial has the value 0 or 1, said polynomial formed in this way then being divided by said generator polynomial G(x), with the remainder after division constituting a polynomial R(x) representing a k-bit structure that is substituted for the k̲ zero bits.

10. A system according to any preceding claim, **characterized in that** b $\leq$ k.

11. A system according to any one of claims 1 to 9, **characterized in that** when b > k, the search for the b̲ erroneous bits provides $2^{b-k}$ solutions which are found in succession by giving the b-k first bits of the b-bit error packet all possible configurations in succession, after which a likelihood criterion is used for selecting one of the $2^{b-k}$ solutions found in this way.

# FIG.1

# FIG.2

1 0 1 0 0 0 1 1 0 0 0 1 1 1

# FIG.3

1 0 1 0 0 0 1 1 0 0 0 1 1 1

# FIG.4

1 0 1 0 0 0 1 1 0 0 0 1 1 1